# EUROPEAN PATENT APPLICATION

(11) **EP 1 416 065 A1**
(43) Date of publication of application: **06.05.2004**
(21) Application number: 03255292.9
(22) Date of filing: 26.08.2003
(51) Int. Cl.: C23C 18/42, H05K 3/18

(54) **Plating method**

(30) Priority: 30.08.2002 US 407044 P; 16.07.2003 US 620951
(71) Applicant: Shipley Company LLC, Marlborough, MA 01752 (US)
(72) Inventor: Rzeznik, Maria Anna, Framingham Massachusetts 01702 (US); Jacques, David L., Northbridge Massachusetts 01534 (US)
(74) Representative: Kent, Venetia Katherine

(57) **Abstract**

The present invention provides compositions and methods for electroless deposition of bright silver layers of uniform thickness. The compositions contain silver ions, water, one or more complexing agents and one or more carboxylic acid-substituted nitrogen-containing heterocyclic compound. Such compositions and methods are particularly useful in the manufacture of electronic devices.

## Description

### Background of the Invention

The present invention relates generally to the field of metal plating. In particular, the present invention relates to the field of immersion silver plating.

Immersion or displacement plating is an electroless plating process, but is given a separate classification in the art. In immersion plating, deposition is by displacement of an elemental metal from a substrate by metal ions in a plating solution. In electroless plating deposition takes place primarily by autocatalytic reduction of metal ions from solution. Such electroless plating requires the presence of a reducing agent.

Immersion plating does not employ an external electric current but rather is an electrochemical displacement reaction which is driven by the position of the substrate metal in the electromotive series relative to the metal to be deposited from solution. Plating occurs when the dissolved metal ions in a plating bath are displaced by a more active (less noble) metal that is contacted with the plating bath.

In the manufacture of printed wiring boards, solderable finishes are typically applied to printed wiring board substrates having pads and/or through holes exposed through a mask, such as a soldermask. Such solderable finishes are often applied by immersion plating as electroless plating can also deposit metal on the surface of the mask, which is undesirable. As an immersion plating reaction is driven by the difference in electrochemical potentials, plating will only occur at areas of exposed metal. However, there is a growing demand for more environmentally acceptable alternatives to lead for use in printed wiring board manufacture. Thus, the use of lead and lead alloys in electronic components faces an uncertain future.

Silver is a more environmentally acceptable alternative to lead and has been suggested for use as a solderable finish. As discussed above, the preferred method of depositing such a solderable finish is by immersion plating. For example, U.S. Patent No. 5,955,141 (Souter et al.) discloses certain immersion silver plating baths suitable for depositing a layer of silver on a printed wiring board.

Limitations on the use of immersion plating exist in printed wiring board manufacture. Such limitations include relatively slow plating rates and limited deposit thicknesses, which are due to the self-limiting nature of immersion plating, i.e. as the metal deposit builds, it tends to mask the underlying base metal, thereby preventing further displacement. These problems have conventionally been addressed using a broad range of additives in the immersion plating bath, such as rate enhancers. However, such additives may adversely affect other important characteristics of the deposit, such as adhesion and deposit uniformity.

Another problem with the use of conventional immersion silver plating baths is that the resulting silver deposit is typically uneven or non-uniform in thickness. Such uneven deposits have a significant variation in thickness across the deposit, i.e. the deposit is quite thick in certain areas and quite thin in others. Thus, layers of silver of uniform thickness are very difficult to achieve with conventional immersion silver plating baths.

Therefore, there is a need for a method of improving the uniformity of immersion plated silver deposits. There is a further need for methods that do not adversely affect other important characteristics of the silver deposit obtained from immersion plating baths.

Picolinic acid has been used in a tarnish remover composition for silver and copper, see Indian Patent No 163677. Zhuang et al., Huaxue Xuebao, 1985, vol. 43, no. 2, pp 120-125, disclose the electrodeposition of silver from a plating bath containing silver nitrate, ammonia and pyridine carboxylic acid. This article does not disclose the use of picolinic acid in an immersion or electroless silver plating bath.

### Summary of the Invention

It has been surprisingly found that an immersion silver plating bath containing one or more carboxylic acid-substituted nitrogen-containing heterocyclic compounds provides a layer of silver of a controlled thickness where the layer of silver has improved thickness uniformity and brightness as compared to silver deposits obtained from conventional immersion deposition methods without such a component.

The present invention provides an immersion silver plating bath composition including one or more sources of silver ions, water, one or more complexing agents and one or more carboxylic acid-substituted nitrogen-containing heterocyclic compounds, wherein the bath is free of ammonia and ammonium ions.

Also provided by the present invention is a method of depositing a layer of silver on a substrate including the step of contacting a substrate having a layer of a metal that is less electropositive than silver with an immersion silver plating bath including one or more sources of silver ions, water, one or more complexing agents, and one or more carboxylic acid-substituted nitrogen-containing heterocyclic compounds, wherein the bath is free of ammonia and ammonium ions.

Further, the present invention provides a method of improving the thickness uniformity of a layer of silver deposited from an immersion silver bath including the steps of: a) providing an immersion silver plating bath including one or more carboxylic acid-substituted nitrogen-containing heterocyclic compounds, one or more sources of silver ions, water, one or more complexing agents; and b) contacting a substrate having a metal layer that is less electropositive than silver with an immersion silver plating bath for a period of time sufficient to deposit a silver layer of a desired thickness.

### Detailed Description of the Invention

As used throughout this specification, the following abbreviations shall have the following meanings, unless the context clearly indicates otherwise: ° C = degrees centigrade; ca. = circa = approximately; g = gram; L = liter; g/L = grams per liter; mL = milliliters; wt% = percent by weight; DI = deionized; cm = centimeters; µin. = microinches; and µm = microns = micrometers (1 µin. = 0.0254 µm).

The terms "printed circuit board" and "printed wiring board" are used interchangeably throughout this specification. As used throughout this specification, the term "complexing agent" includes ligands and chelating agents. Unless otherwise noted, all amounts are percent by weight and all ratios are by weight. All numerical ranges are inclusive and combinable in any order, except where it is clear that such numerical ranges are constrained to add up to 100%.

The present invention provides a method of improving the thickness uniformity of a layer of silver deposited from an immersion plating bath. The term "improving the thickness uniformity" refers to a method of depositing a layer of silver that is more even in its thickenss across the deposit as compared to conventional methods. This is accomplished using an immersion plating bath containing one or more sources of silver ions, water, one or more complexing agents and one or more carboxylic acid-substituted nitrogen-containing hetrocylic compounds, wherein the bath is free of ammonia and ammonium ions. The present invention provides a layer of silver deposited from an immersion plating bath having improved thickness uniformity as compared to a layer of silver immersion deposited using a conventional immersion silver plating bath. The improved thickness uniformity of silver deposits obtained according to the present invention also provides better surface mount connections between a printed wiring board and a surface mount device.

Any water soluble silver salt may be used as the source of silver ions in the present plating baths. Suitable silver salts include, but are not limited to, silver nitrate, silver acetate, silver sulfate, silver lactate, and silver formate. Typically, the source of silver ions is silver nitrate. Mixtures of silver salts may also be used. The one or more sources of silver ions are typically present in an amount sufficient to provide silver ions in solution in a concentration of from 0.06 to 32 g/L, more typically from 0.1 to 25 g/L and still more typically from 0.5 to 15 g/L.

A wide variety of complexing, or chelating, agents may be used. Such chelating agents may be monodentate ligands, such as, cyanide, and pyridine, or multidentate ligands. Suitable multidentate ligands include, but are not limited to: amino acids having from 2 to 10 carbon atoms; polycarboxylic acids such as oxalic acid, adipic acid, succinic acid, malonic acid and maleic acid; amino acetic acids such as nitrilotriacetic acid; alkylene polyamine polyacetic acids such as ethylenediamine tetraacetic acid ("EDTA"), diethylenetriamine pentaacetic acid ("DTPA"), N-(2-hydroxyethyl)ethylenediamine triacetic acid, 1,3-diamino-2-propanol-N,N,N',N'-tetraacetic acid, bis-(hydroxyphenyl)-ethylenediamine diacetic acid, diaminocyclohexane tetraacetic acid, or ethylene glycol-bis-((β-aminoethylether)-N,N' -tetracetic acid); polyamines such as or N,N,N',N'-tetrakis-(2-hydroxypropyl)ethylenediamine, ethylenediamine, 2,2',2"-triaminotriethylamine, triethylenetetramine, diethylenetriamine and tetrakis(aminoethyl)ethylenediamine; citrates; tartrates; N,N-di-(2-hydroxyethyl)glycine; gluconates; lactates; crown ethers; cryptands; polyhydric compounds such as 2,2',2"-nitrilotriethanol; heteroaromatic compounds such as 2,2'-bipyridine, 1,10-phenanthroline and 8-hydroxyquinoline; thio-containing ligands such as thioglycolic acid and diethyldithiocarbamate; and aminoalcohols such as ethanolamine, diethanolamine, and triethanolamine. It will be appreciated by those skilled in the art that a combination of chelating agents may be employed in the present invention.

The complexing agent may be used in a variety of concentrations but is typically present in the immersion silver plating baths either in stoichiometrically equivalent amounts (based on the amount of silver ion) or in a stoichiometric excess so that all the silver ions may be complexed. The term "stoichiometric" as used herein refers to equimolar. In general, the one or more complexing agents are present in a higher molar concentration than the silver ions. Typically, the molar ratio of the complexing agent to silver ions is ≥1:1, more typically≥1.2:1, even more typically ≥2.0:1, and still more typically ≥3.0:1. In general, the total amount of the one or more complexing agents is from 0.1 to 250 g/L. Other suitable amounts of the one or more complexing agents are from 2 to 220 g/L, from 10 to 200 g/L, and from 50 to 150 g/L.

While not wishing to be bound by theory, it is believed that the carboxylic acid-substituted nitrogen-containing heterocyclic compounds function as plating rate inhibitors, thickness uniformity enhancers and brighteners. By "carboxylic acid-substituted nitrogen-containing hetrocylic compound" is meant any nitrogen-containing heterocyclic moiety having one or more of its hydrogens replaced by one or more carboxylic acid groups (-CO₂H). A wide variety of nitrogen-containing heterocyclic moieties may be used, such as, but not limited to, pyridine, piperidine, piperazine, morpholine, pyrrole, pyrrolidine, triazole, and imidazole. Such heterocyclic compounds may be fused to another ring such as benzotriazole, benzimidazole, quinoline or isoquinoline, or may be further substituted, or both. Suitable substitutent groups include without limitation hydroxy, (C₁-C₁₀)alkyl, (C₁-C₁₀)alkoxy, and halo. Exemplary carboxylic acid-substituted nitrogen containing heterocyclic compounds include, but are not limited to, pyridine carboxylic acids, pyridine dicarboxylic acids, pyridine tricarboxylic acids, piperidine carboxylic acids, piperazine carboxylic acids, and pyrrole carboxylic acids. The pyridine carboxylic acids are particularly useful, such as picolinic acid, quonolinic acid, nicotinic acid and fusaric acid. Such compounds are generally commercially available, such as from Sigma-Aldrich (Milwaukee, Wisconsin), or may be prepared by methods known in the literature. The carboxylic acid-substituted nitrogen-containing compound may be used in a variety of concentrations, typically the total amount of such compounds is from 0.01 to 100 g/L, more typically from 0.1 to 50 g/L, even more typically from 0.5 to 25 g/L, and still more typically from 1 to 20 g/L. It will be appreciated by those skilled in the art that more than one carboxylic acid-substituted nitrogen-containing heterocyclic compound may be used.

The present plating baths typically have a pH from 1 to 14. Preferably, the baths have a pH of ≥ 7 and more preferably ≥ 8. Particularly suitable plating baths have a pH of ≥ 8.5 and more particularly ≥ 9. A buffering agent may be added to maintain the pH of the bath at the desired value. Any compatible acids or bases may be used as the buffering agents and may be organic or inorganic. By "compatible" acids or bases it is meant that the acids or bases do not result in precipitation of the silver ions and/or complexing agents(s) from solution, when such acids or bases are used in amounts sufficient to buffer the pH. Exemplary buffering agents include, without limitation, alkali metal hydroxides such as sodium hydroxide or potassium hydroxide, carbonate salts, citric acid, tartaric acid, nitric acid, acetic acid and phosphoric acid.

The immersion silver plating baths may optionally contain one or more additional components. Suitable additional components include, but are not limited to, surfactants or wetting agents, anti-tarnish agents for silver, oxidation inhibitors, levelers, grain refiners, thickness enhancers, defoamers, and dyes. When surfactants are used in the present immersion baths, they are typically used in an amount of from 0.02 to 100 g/L, more typically from 0.1 to 25 g/L, and still more typically from 1 to 15 g/L. Such surfactants may be anionic, cationic, nonionic or amphoteric. The choice of surfactant will depend upon the particular immersion silver plating bath used. When surfactants are used, nonionic surfactants are preferred.

A wide variety of anti-tarnish agents for silver may be used, such as triazoles, tetrazoles, and imidazoles. Such anti-tarnish agents are well known to those skilled in the art. The anti-tarnish agents may be used in an amount from 0.001 to 50 g/L, typically from 0.005 to 25 g/L, and more typically from 0.01 to 10 g/L.

Grain refiners may be added to improve the appearance of the silver deposit. Suitable grain refiners include (C₁-C₆)alcohols and polyalkylene glycols such as polyethylene glycol. Such grain refiners are typically used in an amount from 0.02 to 200 g/L, and preferably from 0.05 to 100 g/L.

Preferably, the immersion silver baths are free of reducing agents capable of reducing silver ions. It is further preferred that the immersion silver baths are free of cyanide ions, ammonia (NH₃) and ammonium ions (i.e. NH₄⁺).

The immersion silver baths are typically prepared by combining the above ingredients in any order. Preferably, the baths are prepared by forming a solution of complexing agent in water and adding the source of silver ions to this solution. The optional ingredients may be combined with the solution in any order.

The immersion silver plating baths may be agitated. Any form of agitation may be used. Suitable agitation includes, but is not limited to, stirring, shaking, swirling, aeration, and sonication. Stirring may be accomplished by any suitable means, such as with an overhead stirrer, paddle stirrer or stirring bar system. Shaking may be accomplished in a variety of ways, such as by moving the substrate to be silver plated back and forth or side to side within the plating bath. Aeration may be accomplished by bubbling or sparging a gas into the plating bath, or by means of jet spray, such as through whirlpool jets. Sparging may be accomplished by bubbling gas into the bath through a fritted means, such as a tube having a frit composed of glass, poly(tetrafluoroethylene) or other inert material. Any gas may be used such as air, oxygen or an inert gas, and preferably air. In a particular embodiment, aeration is used to agitate the bath. Swirling may be accomplished by moving the bath or the substrate to be plated in a substantially circular motion. It will be appreciated by those skilled in the art that a combination of agitation methods may be employed, such as stirring with aeration.

Silver is deposited on any substrate having a metal layer that is less electropositive than silver by contacting the metal layer with the present plating baths. Such contact may be by a variety of means, such as, but not limited to, dipping, spraying, and flood coating. A particularly suitable method of contacting with the present compositions is spraying in a flood mode.

Suitable metals that are less electropositive than silver include, but are not limited to, zinc, iron, tin, nickel, lead, copper or alloys containing one or more of these metals. Particularly suitable metals are tin, copper or alloys of tin or copper. A particularly suitable alloy is tin-copper. In an alternate embodiment, such metal may itself be immersion deposited on a suitable metal underlayer prior to depositing an immersion silver layer according to the present invention. For example, the metal may be tin, such tin deposit being first deposited, such as by immersion, electroless or electrolytic deposition, on copper.

Prior to silver plating, it is preferred that the metal to be plated is cleaned. Cleaning removes oxides and organic contaminants from the metal surface as well as resist residues that may remain from incomplete development of photoresists as well as soldermask residues from copper surfaces. Such cleaning may be by any suitable cleaning processes and/or products. For example, when the metal layer is copper or a copper alloy, it is preferred that the metal layer is cleaned with an acidic cleaning composition. Such cleaning procedures are well within the ability of one skilled in the art. After cleaning, the substrate is typically rinsed, such as with water, and optionally dried. The metal layer may be microetched either before or after the cleaning step, and preferably after the cleaning step. Such microetching is accomplished by contacting the metal layer on the substrate with a microetching composition, such as sulfuric acid/hydrogen peroxide or an alkali metal persulfate such as sodium or potassium persulfate. When such a microetching step is used, the metal layer may then optionally be rinsed with water or an acid, such as with sulfuric acid, to remove any residues from the cleaning and/or microetching steps.

Optionally, the metal to be silver plated may be contacted with a pretreatment composition after cleaning and before contact with the silver plating bath. Any suitable pretreatment composition may be used. Preferred pretreatment compositions include one or more azole compounds, water and a chelating agent.

A wide variety of azole compounds may suitably be used in the present invention. Suitable azoles include, but are not limited to, triazoles, benzotriazoles, tetrazoles, imidazoles, benzimidazoles, indazoles and mixtures thereof. Such azoles may optionally be substituted.

Particularly suitable azole compounds are benzotriazole, substituted benzotriazole, imidazole or substituted imidazole, and more typically benzotriazole, imidazole, (C₁-C₁₆)alkylimidazole, and arylimidazole. Phenylimidazole is the preferred arylimidazole. Exemplary (C₁-C₁₆)alkylimidazoles include methylimidazole, ethylimidazole, propylimidazole, hexylimidazole, decylimidazole and undecylimidazole. Such azole compounds are generally commercially available, such as from Sigma-Aldrich (Milwaukee, Wisconsin) and may be used without further purification. The azole compounds may be used in the present invention in a wide range of amounts. Typically, the azole compound is used in an amount of from 0.005 to 50 g/L. Other suitable amounts are from 0.005 to 20 g/L, and from 0.01 to 15 g/L. The specific amount of azole compound depends upon the particular azole chosen and its solubility in the pretreatment composition.

Such pretreatment compositions may be alkaline or acidic and have a pH of from 1 to 14. The pH of the pretreatment compositions may be varied in order to increase the solubility of the azole compound. For example, the solubility of hydroxybenzotriazole can be increased by increasing the pH of the pretreatment composition.

A wide variety of organic and inorganic acids or organic and inorganic bases can be used to adjust the pH of the pretreatment compositions. Suitable inorganic acids include, but are not limited to: hydrochloric acid, hydrofluoric acid, fluoroboric acid, hydroiodic acid, periodic acid, phosphoric acid, sulfuric acid, and nitric acid. Suitable organic acids include, but are not limited to: alkylsulfonic acids, and arylsulfonic acids. Suitable inorganic bases include, but are not limited to, alkali metal hydroxides carbonates, and ammonium hydroxide. Suitable organic bases include, but are not limited to, tetraalkylammonium hydroxides, and amines. The acids and/or bases are typically present in the pretreatment compositions in an amount sufficient to provide the desired pH.

Preferably, the pretreatment compositions further include one or more chelating agents. Such chelating agents may be monodentate ligands, such as ammonia, cyanide, and pyridine, or multidentate ligands. Preferably, the chelating agents are the same as those used in the subsequent immersion silver plating bath. Other additional components may optionally be used in the pretreatment compositions. Such additional components include, but are not limited to, surfactants, and metal ions. The surfactants may be anionic, cationic, nonionic or amphoteric. When a surfactant is used in the present pretreatment compositions, it is typically present in an amount of at least 0.001 wt%, more typically at least 0.005 wt%, and still more typically at least 0.01 wt%. Mixtures of surfactants may suitably be used.

When metal ions are present in the pretreatment compositions, it is preferred that they are the metal on which silver is to be deposited. For example, when silver is to be immersion deposited on copper, it is preferred that any metal ions present in the pretreatment composition are copper ions.

The amount of metal ions added to the pretreatment composition depends upon the particular metal that is less electropositive than silver, the particular azole compound used and the pH of the pretreatment composition. For example, when copper ions are present in the pretreatment composition, they are typically present in an amount up to 1 g/L, and more typically up to 0.05 g/L.

In general, the metal is contacted with the pretreatment composition for a period of time sufficient to increase the adhesion of a subsequently deposited layer of silver by immersion plating. Such period of time depends upon the particular metal and pretreatment composition used. Typically, a contact time of 1 second to 15 minutes is sufficient, more typically 5 seconds to 10 minutes, and still more typically 10 seconds to 5 minutes.

After the metal has been contacted with the pretreatment composition, it is optionally rinsed, such as with water, and then optionally dried. Such a rinsing step is preferred.

Silver is deposited according to the present invention by contacting a metal that is less electropositive than silver with the present immersion silver plating baths. Such contact may be by any suitable means such as dipping, spraying, and flood coating. When used in vertical plating equipment, the substrate is typically dipped in the present silver plating bath. When used in horizontal plating equipment, the substrate is typically contacted with the present silver plating bath by spraying or flooding.

The contact time of the metal with the immersion silver plating bath is that amount sufficient to deposit the desired thickness of silver. Typically, the contact time is from about 10 seconds to 15 minutes, more typically from 20 seconds to 15 minutes, and still more typically from 30 seconds to 12 minutes.

The present immersion silver plating baths may be used at a variety of temperatures. Suitable temperatures include those in the range of from 10° to 70° C. Other suitable temperature ranges are from 15° to 60° C, and from 20° to 55° C.

The silver deposit typically has a thickness of 35 µin. (0.9 µm) or less, more typically 30 µin. (0.76 µm) or less, and even more typically 25 µin. (0.64 µm) or less. Following deposition, the silver layer may be rinsed such as with water. The silver layer may optionally be dried prior to subsequent processing steps.

In general, the metal that is less electropositive than silver is a metal layer on a substrate. A wide variety of substrates having a layer of a metal that is less electropositive than silver may be plated according to the present invention. Suitable substrates include, but are not limited to, jewelry, decorative objects, object d'art, semiconductor packaging, lead frames, solder bumps, metal powder, metal foil such as copper foil, and printed wiring board substrates. The present invention is particularly suited for depositing a solderable silver finish on a printed wiring board. Further, the present invention provides a method of manufacturing a printed wiring board including the steps of contacting a metal that is less electropositive than silver with an immersion silver plating bath containing one or more sources of silver ions, water, one or more complexing agents and one or more carboxylic acid-substituted nitrogen-containing heterocyclic compounds to provide a layer of silver, wherein the immersion silver plating bath is free of ammonia and ammonium ions. Such a silver layer provides a solderable finish on the printed wiring board. Such solderable finishes are typically applied to a printed wiring board substrate having pads, through holes and a mask, such as a soldermask. In such a printed wiring board substrate, the exposed pads and through holes generally contain a layer of copper.

In yet another embodiment, the present invention is suitable for providing a printed wiring board substrate having exposed pads and/or through holes including a tin-silver alloy as the solderable finish. Thus, the present invention further provides a method for manufacturing a printed wiring board including the steps of: a) providing a printed wiring board substrate having pads, through holes, soldermask and a layer of a metal; b) depositing a layer of tin on the metal layer; c) then contacting the tin plated printed wiring board substrate with an immersion silver plating bath including one or more sources of silver ions, water, one or more complexing agents and one or more carboxylic acid-substituted nitrogen-containing heterocyclic compounds, to form an immersion silver deposit on the tin deposit; and d) heating the silver-tin deposit to form a tin-silver alloy. In one embodiment, the layer of metal is a layer of a metal that is less electropositive than tin and the tin is deposited from an immersion tin plating bath containing one or more sources of tin ions, water and one or more complexing agents. In another embodiment, the layer of metal is a layer of any conductive metal and the tin is deposited by electroless or electrolytic plating.

In a further embodiment, bright silver deposits are obtained by the present method including the step of contacting a substrate having a layer of a metal that is less electropositive than silver with an immersion silver plating bath comprising one or more sources of silver ions, water, one or more complexing agents and one or more carboxylic acid-substituted nitrogen-containing heterocyclic compounds, wherein the bath is free of ammonia and ammonium ions.

When the present immersion silver plating baths have a pH ≥ 8, and in particular at pH 9, silver deposits having improved thickness uniformity are obtained. However, the adhesion of the deposited silver layer deposited from these baths becomes diminished as compared to the adhesion of a silver layer deposited from a similar plating bath having a lower pH. Accordingly, it is preferred that when the immersion silver plating bath has a pH of ≥ 8, that an adhesion promoter be added to the immersion silver plating bath. Exemplary adhesion promoters include, but are not limited to, amino acids such as glutamic acid, glycine, lysine, β-alanine and aspartic acid; hydroxy-substituted aromatic compounds such as hydroxybenzotrazole and 5-methoxyresorcinol; and sulfur-containing carboxylic acids such as mercaptodiacetic acid. The use of such adhesion promoters in immersion silver plating baths that do not contain at least one carboxylic acid-substituted nitrogen-containing heterocyclic compound results in silver deposits that are dark (i.e. not bright) and non-uniform in thickness. Surprisingly it has been found that immersion silver plating baths containing both at least one adhesion promoter and at least one carboxylic acid-substituted nitrogen-containing heterocyclic compound where the bath has a pH of ≥ 8 provide bright, highly adherent silver deposits having improved thickness uniformity as compared to silver deposits obtained from conventional immersion silver plating baths.

A wide variety of post-treatments may be used to treat the silver layer deposited according to the present invention. For example, it is well known that silver, such as in silver films, tarnishes upon prolonged exposure to air. Thus, in certain applications it is desirable to contact the freshly deposited silver layer with a tarnish inhibitor or anti-tarnish agent. Such silver tarnish inhibitors are well-known to those skilled in the art and include those described above. The silver deposit may be contacted with the tarnish inhibitor by any suitable means, such as dipping, spraying, and flood coating. The use of a tarnish inhibitor subsequent to plating is not required, but may optionally be used. Other conventional post-treatments may also be advantageously used.

Silver layers having improved thickness uniformity, i.e. less variation in thickness, are provided by the present immersion plating baths, as compared to conventional immersion silver plating baths. Accordingly, the present invention provides a method for improving the thickness uniformity of a layer of silver deposited from an immersion silver plating bath including the steps of: a) providing an immersion silver plating bath including one or more sources of silver ions, water, one or more complexing agents and one or more carboxylic acid-substituted nitrogen-containing heterocyclic compounds; and b) contacting a substrate having a metal layer that is less electropositive than silver with the immersion silver plating bath for a period of time sufficient to deposit a desired silver layer.

The present invention is particularly suitable for use in the manufacture of a wide variety of electronic devices in addition to printed wiring boards, such as lead frames, semiconductor packaging, and lead-free solder bumps on wafers, such as tin-silver and tin-copper-silver solders.

The following examples are expected to further illustrate various aspects of the present invention, but are not intended to limit the scope of the invention in any aspect.

### Example 1 (Comparative)

An immersion silver plating bath was prepared by combining 100 g/L nitrilotriacetic acid ("NTA") and 1 g/L silver nitrate in deionized water (final volume 1L). The pH of the bath was adjusted to 9. The bath temperature was ca. 50 °C.

### Example 2

The procedure of Example 1 was repeated, except that 1 g/L picolinic acid was also added to the composition to provide this Example. The pH was again adjusted to 9 and the bath temperature was ca. 50 °C.

### Example 3

Copper panels (2 x 6 inches or 5 x 15 cm) were submerged in a commercially available acid cleaner to remove oxides and organic residues from the copper surface, followed by rinsing with water. The copper panels were next contacted with a commercially available sulfuric acid/hydrogen peroxide-based microetching composition to produce optimum copper surface uniformity and texture, followed by rinsing with water. After contact with the microetching composition, the copper panels were then submerged in either the silver plating bath of Example 1 or Example 2 for 10 minutes.

The thickness of the resulting silver layer on the copper panels for each silver formulation was determined by X-ray fluorescence ("XRF") spectroscopy for a number of points on the panels and the data are reported as a range of thicknesses in Table 1.

**Table 1**

| Bath Example | NTA (g/L) | Picolinic Acid (g/L) | Thickness Range (µm) |
|---|---|---|---|
| 1 | 100 | 0 | 0.26 - 0.70 |
| 2 | 100 | I | 0.15 - 0.22 |

The data above clearly show that addition of picolinic acid to immersion silver plating baths has a dramatic effect on the thickness and uniformity of the resulting silver deposit. The deposits obtained are much more uniform than deposits obtained from immersion plating baths that do not contain picolinic acid.

### Example 4

The procedure of Example 1 was repeated, except that 3, 5, 6, 8, and 10 g/L picolinic acid was also added to the compositions to provide Examples 4A, 4B, 4C, 4D, and 4E, respectively. The pH was again adjusted to 9 and the bath temperature was approximately 50 °C.

Copper panels (2 x 6 inches or 5 x 15 cm) were cleaned and microetched according to the procedure of Example 3 and then submerged in the silver plating baths of this Example for 10 minutes. The thickness of the resulting silver layer on the copper panels for each silver formulation was determined by XRF spectroscopy according to the procedure of Example 3 and the data are reported as thickness ranges in Table 2.

**Table 2**

| Bath Example | NTA (g/L) | Picolinic Acid (g/L) | Thickness Range (µm) |
|---|---|---|---|
| 4A | 100 | 3 | 0.12 - 0.17 |
| 4B | 100 | 5 | 0.085 - 0.12 |
| 4C | 100 | 6 | 0.082 - 0.10 |
| 4D | 100 | 8 | 0.059 - 0.078 |
| 4E | 100 | 10 | 0.052 - 0.066 |

The data above clearly show that the thickness and uniformity of a deposited silver layer can be controlled by incorporating selected amounts of picolinic acid into a silver immersion plating bath. The deposits obtained are significantly more uniform than deposits obtained from immersion plating baths not containing picolinic acid.

### Example 5 (Comparative)

Immersion silver plating baths were as described in Example 1. To these solutions, 0.05 and 0.12 g/L 1-hydroxybenzotriazole was added to provide Examples 5A and 5B, respectively. The solutions were diluted to a final volume with deionized water. The pH of the bath was adjusted to 9 and the bath temperature was approximately 50 °C.

### Example 6

The procedure of Example 5 was repeated, except that picolinic acid was added to each of Examples 5A and 5B, Examples 6A and 6B, respectively. The amounts of picolinic acid were as shown in Table 3. The pH of the baths was adjusted to 9 and the temperature of the baths was approximately 50 °C.

Copper panels (2 x 6 inches or 5 x 15 cm) were cleaned and microetched according to the procedure of Example 3 and were then submerged in the silver plating baths of Examples 5A, 5B, 6A and 6B for 10 minutes. The thickness of the resulting silver layer on the copper panels for each silver formulation was determined by XRF according to Example 3 panel and the data are reported as a thickness ranges in Table 3.

**Table 3**

| Bath Example | NTA (g/L) | Picolinic Acid (g/L) | 1-Hydroxybenzotriazole (g/L) | Thicknesss Range (µm) | Appearance |
|---|---|---|---|---|---|
| 5A | 100 | 0 | 0.10 | 0.13-0.26 | Dark brown |
| 5B | 100 | 0 | 0.12 | 0.12 - 0.28 | Brown |
| 6A | 100 | 5.14 | 0.05 | 0.061 - 0.088 | Bright |
| 6B | 100 | 2.99 | 0.12g | 0.036 - 0.045 | Bright |

Without the addition of picolinic acid, the deposited silver is dark and the plating is non-uniform. Addition of picolinic acid significantly improves the brightness and uniformity of the deposited silver.

### Example 7 (Comparative)

The procedure for Example 1 was repeated, except that mercaptodiacetic acid was added to each bath to provide Examples 7A and 7B. The concentrations of additives are as noted in Table 4. The solutions were diluted to a final volume with deionized water. The pH of the bath was adjusted to 9 and the bath temperature was approximately 50 °C.

### Example 8

The procedure of Example 7 was repeated, except that 6 g/L picolinic acid was also added to the compositions of Examples 7A and 7B to provide Examples 8A and 8B, respectively. The pH was again adjusted to 9 and the bath temperature was approximately 50 °C.

Copper panels (2 x 6 inches or 5 x 15 cm) were cleaned and microetched according to the procedure of Example 3 and were then submerged in either the silver plating baths of Example 7 or Example 8 for 10 minutes. The thickness of the resulting silver layer on the copper panels for each silver formulation was determined by XRF according to Example 3 and the data are reported as a range of thicknesses in Table 4.

**Table 4**

| Bath Example | NTA (g/L) | Picolinic Acid (g/L) | Mercaptodiacetic acid (g/L) | Thicknesss Range (µm) | Appearance |
|---|---|---|---|---|---|
| 7A | 100 | 0 | 0.1 | 0.23 - 0.5 1 | Yellowish |
| 7B | 100 | 0 | 1.0 | 0.20 - 0.47 | Grey/brown |
| 8A | 100 | 6 | 0.1 g | 0.075 - 0.11 | Bright |
| 8B | 100 | 6 | 1.0g | 0.080-0.15 | Bright |

Without the addition of picolinic acid, the deposited silver is dark and the plating is non-uniform. Addition of picolinic acid significantly improves the brightness and thickness uniformity of the deposited silver.

### Example 9 (Comparative)

Three immersion silver plating baths were prepared by combining 100g/L NTA and 1 g/L silver nitrate which was diluted to final volume (1L) with deionized water. These silver formulations, Examples 9A, 9B, and 9C also contained 1.0, 3.0, and 5.0 g/L L-glutamic acid, respectively. The pH of the baths was adjusted to 9 and the temperature of the baths was approximately 50 °C.

### Example 10

The procedure of Example 9 was repeated, except that 6 g/L picolinic acid was also added to each of the compositions to provide Examples 10A, 10B, and 10C, respectively. The pH was again adjusted to 9 and the bath temperature was approximately 50 °C.

Copper panels (2 x 6 inches or 5 x 15 cm) were cleaned and microetched according to the procedure of Example 2 and were then submerged in either the silver plating baths of Example 9 or Example 10 for 10 minutes. The thickness of the resulting silver layer on the copper panels for each silver formulation was determined by XRF according to Example 3 and the data are reported as thickness ranges in Table 5.

**Table 5**

| Bath Example | NTA (g/L) | Picolinic Acid (g/L) | L-Glutamic Acid (g/L) | Thicknesss Range (µm) | Appearance |
|---|---|---|---|---|---|
| 9A | 100 | 0 | 1.0 | 0.16 - 0.30 | Brown |
| 9B | 100 | 0 | 3.0 | 0.11 - 0.29 | Brown |
| 9C | 100 | 0 | 5.0 | 0.11 - 0.24 | Brown |
| 10A | 100 | 6 | 1.0 | 0.10 - 0.15 | Bright |
| 10B | 100 | 6 | 3.0 | 0.081 - 0.15 | Bright |
| 10C | 100 | 6 | 5.0 | 0.099 - 0.15 | Bright |

Without the addition of picolinic acid, the deposited silver is dark and the plating is non-uniform. Addition of picolinic acid significantly improves the brightness and thickness uniformity of the deposited silver.

### Example 11

A number of plating baths are prepared by the procedure of Example 2 except that the picolinic acid is replaced with one of the compounds in the amount shown in Table 6.

**Table 6**

| Compound | Amount (g/L) |
|---|---|
| Nicotinic acid | 2 |
| Isonicotinic acid | 15 |
| Quinolinic acid | 1 |
| Fusaric acid | 0.5 |
| Isonipecotic acid | 20 |
| Nipecotic acid | 6 |
| 2,6-pyridine dicarboxylic acid | 18 |
| Piperazine-2-carboxylic acid | 12 |
| Pyrrole-2-carboxylic acid | 9 |
| Pipecolinic acid | 5 |

### Example 12

Copper panels are cleaned and microetched according to the procedure of Example 3, and are then to be contacted with the plating baths of Example 11, to deposit a layer of silver.

## Claims

1. An immersion silver plating bath composition comprising one or more sources of silver ions, water, one or more complexing agents and one or more carboxylic acid-substituted nitrogen-containing heterocyclic compounds, wherein the bath is free of ammonia and ammonium ions.

2. The composition of claim I wherein the bath has a pH of ≥ 7.

3. The composition of claim 1 wherein the bath has a pH of≥8.5.

4. The composition of claim 1 wherein the carboxylic acid-substituted nitrogen-containing heterocyclic compound is chosen from picolinic acid, quinolinic acid, nicotinic acid, fusaric acid, isonipecotic acid, nipecotic acid, pyridine dicarboxylic acid, piperazine carboxylic acid, pyrrole carboxylic acid and piperolinic acid.

5. The composition of claim 1 wherein the carboxylic acid-substituted nitrogen-containing heterocyclic compound comprises a nitrogen-containing heterocyclic moiety chosen from pyridine, piperidine, piperazine, pyrrole, morpholine, pyrrolidine, triazole, and imidazole.

6. The composition of claim 1 wherein at least one complexing agent is a mulitdentate ligand.

7. The composition of claim 1 wherein at least one complexing agent is chosen from cyanide, pyridine; amino acids having from 2 to 10 carbon atoms; polycarboxylic acids; amino acetic acids; pyridine carboxylic acid and pyridine dicarboxylic acid; alkylene polyamine polyacetic acids, polyamines; citrates; tartrates; N,N-di-(2-hydroxyethyl)glycine; gluconates; lactates; crown ethers; cryptands; polyhydric compounds; heteroaromatic compounds; thio-containing ligands and aminoalcohols.

8. A method of depositing a layer of silver on a substrate comprising the step of contacting a substrate having a layer of a metal that is less electropositive than silver with the immersion silver plating bath composition of any one of claims 1 to 7.

9. A method of improving the thickness uniformity of a layer of silver deposited from an immersion silver plating bath comprising the steps of: a) providing the immersion silver plating bath composition of any one of claims 1 to 7; and b) contacting a substrate having a metal layer that is less electropositive than silver with the immersion silver plating bath composition for a period of time sufficient to deposit a desired silver layer.
